# EUROPÄISCHE PATENTSCHRIFT

(11) **EP 2 812 921 B1**
(45) Veröffentlichungstag und Bekanntmachung des Hinweises auf die Patenterteilung: **16.11.2016**
(21) Anmeldenummer: 13709153.4
(22) Anmeldetag: 11.02.2013
(51) Int. Cl.: H01L 29/36, H01L 21/22, H01L 29/167, H01L 29/165, H01L 29/864, H01L 21/329, H01L 31/0288, H01L 31/101, H01L 31/18, H01L 33/02, H01S 5/30, H01L 33/00, H01L 33/34, H01S 5/183

(54) **HALBLEITERBAUELEMENTE MIT STEILEM PHOSPHOR-PROFIL IN EINER GERMANIUMSCHICHT**
SEMICONDUCTOR COMPONENTS WITH STEEP PHOSPHORUS PROFILE IN A GERMANIUM LAYER
COMPOSANT À SEMI-CONDUCTEURS PRÉSENTANT UN PROFIL PHOSPHORE À FORTE PENTE DANS UNE COUCHE DE GERMANIUM

(30) Priorität: 10.02.2012 DE 102012202067
(43) Veröffentlichungstag der Anmeldung: 17.12.2014
(73) Patentinhaber: IHP GmbH-Innovations for High Performance Microelectronics / Leibniz-Institut für innovative Mikroelektronik, 15236 Frankfurt / Oder (DE)
(72) Erfinder: YAMAMOTO, Yuji, 15230 Frankfurt (Oder) (DE); TILLACK, Bernd, 15234 Frankfurt (Oder) (DE)
(74) Vertreter: Eisenführ Speiser
(86) Internationale Anmeldenummer: PCT/EP2013/052699
(87) Internationale Veröffentlichungsnummer: WO 2013/117765

(56) Entgegenhaltungen:
- US-B1- 6 437 372
- YU HYUN-YONG ET AL: "Effect of uniaxial-strain on Ge p-i-n photodiodes integrated on Si", APPLIED PHYSICS LETTERS, AIP, AMERICAN INSTITUTE OF PHYSICS, MELVILLE, NY, US, Bd. 95, Nr. 16, 22. Oktober 2009 (2009-10-22), Seiten 161106-161106, XP012126120, ISSN: 0003-6951, DOI: 10.1063/1.3254181
- LI CHENG ET AL: "Enhanced photoluminescence of strained Ge with a Î'-doping SiGe layer on silicon and silicon-on-insulator", APPLIED PHYSICS LETTERS, AIP, AMERICAN INSTITUTE OF PHYSICS, MELVILLE, NY, US, Bd. 95, Nr. 25, 21. Dezember 2009 (2009-12-21), Seiten 251102-251102, XP012126893, ISSN: 0003-6951, DOI: 10.1063/1.3275863

## Beschreibung

Die Erfindung betrifft ein Verfahren zur Begrenzung einer Dotierstoff-Diffusion in auf einem Silizium-Substrat aufgebrachtem Germanium gemäß Anspruch 1 und ein Lichtabsorbierendes oder -emittierendes Halbleiterbauelement gemäß Anspruch 7.

Bei der Fabrikation von Halbleiterbauelementen übliche Verfahren zum Einbringen von Dotierstoffen erfordern in der Regel thermische Behandlungen. Bei derartigen, auch ein Rapid Thermal Annealing (RTA) einschließenden thermischen Behandlungen, die bei unterschiedlichsten Temperaturen für ganz unterschiedliche Zeiträume durchgeführt werden können, werden unerwünschte Schäden des Halbleitergitters weitestgehend beseitigt. Daneben werden thermische Behandlungsschritte auch zur Aktivierung der eingebrachten Dotierstoffe bzw. zu deren homogener Verteilung eingesetzt. Dies ist insbesondere erforderlich, wenn in einem Schichtaufbau bestimmte Schichtdicken der Dotierstoffverteilung erreicht werden müssen.

Neben den gewünschten Effekten einer derartigen Einstellung der Dotierstoffverteilung und -konzentration treten häufig auch unerwünschte Interdiffusionen verschiedenartiger Dotierstoffe aus aneinander angrenzenden Schichten auf.

Es sind bereits eine Vielzahl von Verfahrenstechniken bekannt, die zum Ziel haben, eine derartige Interdiffusion zu vermeiden. So das Aufbringen von an sich nicht leitenden Zwischenschichten bis hin zu einer besonderen Wahl einer Abfolge nass- und/oder trockenchemischer Ätz-Prozesse und ausgefeilter Maskentechniken. Dennoch treten Schwierigkeiten auf.

Yu Hyun-Yong et al. ("Effect of uniaxial-strain on Ge p-i-n photodiodes integrated on Si". Applied physics letters, AIP, American Institute of Physics, Melville, NY, US Bd. 95, Nr. 16, 22. Oktober 2009, Seiten 161106-1 161106-3. DOI: 10.1063/1.3254181) zeigen den Einfluss von einachsiger Zugdehnung und Stauchung auf in Silicium integrierten Ge p-i-n Photodioden mittels vier-Punkt Biegestrukturen, und offenbaren dabei eine Ge p-i-n Photodiode mit einer Schichtstruktur, die eine mit Phosphor dotierte Germaniumschicht aufweist.

Aus dem Bereich der III-V-Halbleiter ist aus der US 6,437,372 B1 eine dünne, Spikeartige Diffusionsbarriere in einem optoelektronischen Bauelement bekannt. Dabei werden in eine p-i-n-Struktur in einem Übergangsbereich zwischen einer dotierten Indiumphosphid(InP)-Schicht und einer die aktive Zone der pin-Struktur bildenden Schicht höheren Widerstands eine oder mehrere eine Diffusion von Dotierstoffen hemmenden Diffusionsbarriereschichten eingebracht. Die Diffusionsbarriere soll eine Diffusion von in die Indiumphosphid-Schicht eingebrachten Dotierstoffen in die aktive Zone entweder aus einem intrinsischen IndiumGalliumArsenidPhosphid (InGaAsP) oder durch eine Eisendotierte InP-Schicht verhindern. Dazu werden bei der Schichtherstellung auf die aktive Zone eine intrinsische Indiumphosphid-Schicht gefolgt von einer dünnen AluminiumSchicht mit einer Schichtdicke von ungefähr einem Nanometer 1 nm aufgebracht, an die sich dann die dotierte Indiumphosphid-Deckschicht anschließt. Es können in einer weiteren Ausführung auch eine Vielzahl von undotierten Indiumphosphid- und Aluminium-Schichten vorgesehen werden. Schließlich ist es gemäß der US 6,437,372 B1 auch bekannt, bei einem MESA-artigen Aufbau eine laterale Begrenzung der Schichten durch eine undotierte Halbleiterschicht und einen Aluminium-Spike vorzusehen.

Eine derartige Verwendung von Diffusions-Barriereschichten ist bei den III-V-Halbleitern daher von Bedeutung, weil hier häufig Schichten aus ganz unterschiedlichen Elementen der Gruppen III und V des Periodensystems aufgebaut werden, die übereinander in Halbleiterbauelementen angeordnet werden. Durch eine Diffusion einer oder mehrerer III-oder V-Elemente können jeweils lokal andere Halbleiterverbindungen entstehen, deren ungewollte Ausbildung es zu verhindern gilt.

Der vorliegenden Erfindung liegt die technische Problemstellung zugrunde, eine Diffusion von Phosphor in Germaniumschichten zur Einstellung besonders steiler Dotierstoffprofile zu verhindern bzw. einzuschränken. Der Erfindung stellt sich daher die Aufgabe, eine Dotierstoff-Diffusion in Germanium zumindest zu begrenzen bzw. eventuell sogar zu verhindern. Ferner liegt der vorliegenden Erfindung die Aufgabe zugrunde, Halbleiterbauelemente, insbesondere Licht-absorbierende oder - emittierende Halbleiterbauelemente, die dotierte Germaniumschichten enthalten, hinsichtlich ihre Quantenausbeute bzw. Gütefaktoren und Energie des entsprechenden optischen Übergangs zu verbessern.

In einem ersten Aspekt schlägt die Erfindung zu Lösung dieser Aufgaben ein Verfahren zur Herstellung eines Halbleiterbauelements vor, umfassend: Herstellen einer Schichtstruktur, die eine mit Phosphor als Dotierstoff versehene Germaniumschicht aufweist, wobei mindestens eine Deltadotierung mit Silizium entweder in der Germaniumschicht oder in mindestens einer an die Germaniumschicht angrenzenden Nachbarschicht der Schichtstruktur angeordnet wird, und wobei die Nachbarschicht nicht oder in einer anderen Konzentration als die Germaniumschicht mit Phosphor dotiert wird.

In einem zweiten Aspekt schlägt die Erfindung zur Lösung dieser Aufgaben ein Halbleiterbauelement vor, mit einer Schichtstruktur, die eine mit Phosphor als Dotierstoff versehene Germaniumschicht aufweist, wobei mindestens eine Deltadotierung mit Silizium entweder in der Germaniumschicht oder in mindestens einer an die Germaniumschicht angrenzenden Nachbarschicht der Schichtstruktur angeordnet ist, und wobei die Nachbarschicht nicht oder in einer anderen Konzentration als die Germaniumschicht mit Phosphor dotiert ist.

Mit Vorteil kann mit dem erfindungsgemäßen Verfahren und dem erfindungsgemäßen Halbleiterbauelement ein besonders steiles Dotierstoffprofil von Phosphor in Germanium erzielt werden. Dies ist beispielsweise hilfreich für die Herstellung direkter optischer Übergange in dem Halbleitermaterial Germanium. Die Deltadotierung wird vorzugsweise hergestellt, bevor die Schichtstruktur in einem Prozessschritt einer Temperatur von 550 °C oder höher ausgesetzt wird.

Die Deltadotierung wird in der Fachwelt und in der vorliegenden Anmeldung mit gleicher Bedeutung auch als Spike bezeichnet. Man spricht hierbei auch von "Atomic layer doping".

Nachfolgend werden Ausführungsbeispiele des Verfahrens des ersten Aspekts der Erfindung beschrieben. Die zusätzlichen Merkmale der verschiedenen Ausführungsbeispiele können zu Bildung weiterer Ausführungsformen der Erfindung miteinander kombiniert werden.

Vorzugsweise wird die Deltadotierung mit Silizium in einer Schichtdicke hergestellt, welche geeignet ist, unter Temperaturen bis zu einem Maximalwert zwischen 600 °C und 750 °C eine Diffusion des Dotierstoffs Phosphor zwischen der Germaniumschicht und der Nachbarschicht durch die Deltadotierung hindurch vollständig zu vermeiden oder im Vergleich mit einer ohne die Deltadotierung hergestellten Schichtstruktur zu reduzieren. Der mit der Deltadotierung unter diesen Herstellungsbedingungen versehende Schichtabschnitt bildet eine besonders wirksame Diffusionsbarriere gegen die Ausdiffusion von Phosphor.

Eine besonders gute Barrierewirkung wird erzielt, wenn die Deltadotierung mit Silizium mit einer Dosis erfolgt, welche der Dosis einer ganzflächigen Abscheidung von Silizium mit einer Schichtdicke von 1 bis 4 Monolagen entspricht. Die Deltadotierung kann beispielsweise mittels Atomic Layer Processing hergestellt werden.

Insgesamt wird die Deltadotierung vorzugsweise in einem Schichtabschnitt einer Dicke von zwischen 1 und 10 Monolagen der Germaniumschicht oder der Nachbarschicht eingebaut. Eine Schichtdicke dieser dünnen Dotierungsschicht von mehr als einem Nanometer - natürlich im üblichen Dickenbereich des Atomic layer dopings verbleibend - ist jedoch nicht ausgeschlossen.

Mit dem erfindungsgemäßen Verfahren können besonders dünne Ge:P-Schichtdicken erzielt werden. Vorzugsweise wird zu diesem Zweck zur Dotierung mit Phosphor eine Phosphorabscheidung in situ auf einer Germaniumoberfläche während einer Wachstumsunterbrechung der in Herstellung befindlichen Germaniumschicht oder mittels Phosphor-Koabscheidung bei der Herstellung der Germaniumschicht durchgeführt. Phosphor sollte zur Herstellung besonders dünner Phosphor-Spikes in Germanium bei einer Temperatur zwischen 200 °C und 450 °C, abgeschieden werden. Zur Aufrechterhaltung eines solchen Spikes während nachfolgender Prozessschritte bei höheren Temperaturen sollte im Abstand von jeweils etwa 1 nm unterhalb und oberhalb des abgeschiedenen Phosphors jeweils eine Deltadotierung der Germaniumschicht mit Silizium erfolgen.

Bei dem erfindungsgemäßen Verfahren wird als Dotierstoff Phosphor eingesetzt. Mit dem erfindungsgemäßen Verfahren kann jedoch auch eine Diffusion anderer, den Halbleiter Germanium löcher- oder elektronenleitend machender Dotierstoffe verhindert oder begrenzt werden.

Nachfolgend werden Ausführungsbeispiele des Halbleiterbauelements des zweiten Aspekts der Erfindung beschrieben. Auch hier können die zusätzlichen Merkmale unterschiedlicher Ausführungsbeispiele mit einander kombiniert werden, um weiter Ausführungsformen des Halbleiterbauelements zu bilden.

Wie bereits als Ausführungsform des Verfahrens beschrieben, zeigt sich die Deltadotierung vorzugsweise in einem Schichtabschnitt einer Dicke von zwischen 1 und 10 Monolagen der Germaniumschicht oder der Nachbarschicht, das heißt, sie ist vorzugsweise vollständig enthalten. Andere Ausführungsformen sehen ein etwas breiteres Konzentrationsprofil der Deltadotierung vor.

Bei einem Ausführungsbeispiel ist die Schichtstruktur auf einem Substrat mit einer Siliziumoberfläche, wie beispielsweise einem Silizium (bulk oder SOI)-Substrat abgeschieden und umfasst wenigstens eine auf der Substratoberfläche aufgebrachte, dotierte Siliziumschicht eines ersten Leitfähigkeitstyps, eine auf der dotierten Siliziumschicht aufgebrachte, die Germaniumschicht bildende erste Germaniumschicht und eine auf dieser aufgebrachte, die Nachbarschicht bildende zweiten Germaniumschicht, wobei die erste und die zweite Germaniumschicht einen dem ersten Leitfähigkeitstyp entgegengesetzten zweiten Leitfähigkeitstyp aufweisen, die zweite Germaniumschicht höher dotiert ist als die erste Germaniumschicht ist und wobei die erste Germaniumschicht nahe ihrer vom Substrat abgewandten Grenzfläche die Deltadotierung mit Silizium einmal oder mit Abstand wiederholt aufweist. Zusätzlich kann die erste Germaniumschicht zusätzlich nahe ihrer dem Silizium-Substrat zugewandten Grenzfläche die Deltadotierung mit Silizium einmal oder mit Abstand wiederholt aufweisen. Anstelle eines Substrats mit einer Siliziumoberfläche kann ein Substrat mit einer Germaniumoberfläche, beispielsweise ein Germanium-Substrat verwendet werden.

Eine andere Ausführungsform des erfindungsgemäßen Halbleiterbauelements zeichnet sich durch eine weitere, zwischen dem Substrat und der ersten Germaniumschicht vorgesehene, dotierte Siliziumschicht aus, deren elektrische Leitfähigkeit von derjenigen der wenigstens einen Siliziumschicht abweicht. Die weitere, zwischen dem Substrat und der ersten Germaniumschicht vorgesehene, dotierte Siliziumschicht kann aber auch einen Leitfähigkeitstyp haben, der von demjenigen der wenigstens einen Siliziumschicht abweicht.

Bevorzugt ist zwischen der wenigstens einen Siliziumschicht und dem Substrat eine Oxidschicht vorgesehen. Auch in einem solchen Fall ist ein tafelbergartiger Aufbau, MESA-struktureller Aufbau, des erfindungsgemäßen Halbleiterbauelements vorteilhaft. Weiter bevorzugt kann sich das erfindungsgemäße Halbleiterbauelement dann durch zwei weitere, die wenigstens eine Siliziumschicht seitlich umgebende Siliziumschichten auszeichnen.

Zum Einsatz eines erfindungsgemäßen Halbleiterbauelements als Lichtemitter oder Lichtabsorber ist die höchstdotierte, am weitesten von der Oberfläche abgewandte Siliziumschicht mit einem elektrischen Kontakt versehen. Ebenso kann die zweite Germaniumschicht mit wenigstens einem Kontakt versehen sein.

Die Erfindung wird nachfolgend im Zusammenhang mit den beiliegenden, in unterschiedlichen Maßstäben und zum Teil stark vereinfachend gehaltenen Zeichnungen an Ausführungsbeispielen näher erläutert. In den Zeichnungen sind einander entsprechende Merkmale unterschiedlicher Ausführungsbeispiele mit den gleichen Bezugszeichen versehen. Es zeigen:
Fig. 1 einen mit einem erfindungsgemäßen Verfahren erreichbaren Schichtaufbau einer Halbleiterstruktur,
Fig. 2 ein Dotierstoff-Tiefenprofil und ein Barrierenmaterial-Tiefenprofil in Germanium gemäß der Erfindung,
Fig.3 einen Aufbau einer ersten Ausführungsform eines erfindungsgemäßen Halbleiter-bauelementes und
Fig. 4 einen Aufbau einer zweiten Ausführungsform eines erfindungsgemäßen Halbleiterbauelementes

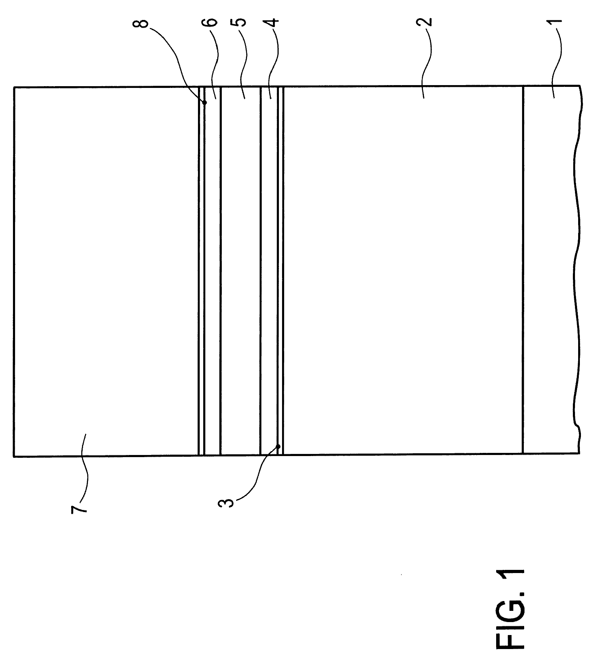

Mit der erfindungsgemäßen Verfahrensführung und er erfindungsgemäßen Schichtstruktur eines Halbleiterbauelements kann eine Diffusion des Dotierstoffes Phosphor in Germanium durch Einbringen einer Silizium-Deltadotierung, auch als Silizium-Spike bezeichnet, weitestgehend beschränkt, vorzugsweise sogar vollständig verhindert werden. Fig. 1 zeigt schematisch einen mit einem erfindungsgemäßen Verfahren erreichbaren Schichtaufbau eines Halbleiterbauelements. Bei dem Ausführungsbeispiel der Fig. 1 wird auf ein Silizium- oder Germanium-Substrat 1 eine 200 nm dicke nicht-dotierte Germanium-Zwischenschicht (Puffer-Schicht) 2 aufgebracht, die von einer einem Silizium-Spike 3 gefolgt wird. Auf den Silizium-Spike 3 wird eine 10 nm dicke nicht-dotierte Germaniumschicht 4 aufgebracht. Auf die Germaniumschicht 4 wird eine 30 nm dicke p-dotierte Germaniumschicht 5, gefolgt von einer weiteren, 10 nm dicken Germaniumschicht 6 aufgebracht. Bevor eine 150 nm dicke ebenfalls nicht-dotierte Germanium-Deckschicht (capping-layer) 7 aufgebracht wird, wird auf der vom Substrat 1 am weitesten abgewandten undotierten Germaniumschicht 6 ein weiterer Silizium-Spike 8 aufgebracht.

Diese auf einem vorzugsweise in (100) Richtung orientierten Substrat 1 aufgebrachte, insgesamt mit dem Bezugszeichen 10 bezeichnete Schichtstruktur wird erfindungsgemäß mit üblichen in der Halbleiter-Technologie bekannten Verfahren wie Molekularstrahlepitaxie (Molecular Beam Epitaxy) oder Gasphasenabscheidung (Chemical Vapour Deposition) erzeugt.

Das mit der Schichtstruktur 10 versehene Substrat wird einer Temperatur von höchstens 550 °C bei der Abscheidung der unterschiedlichen Schichten ausgesetzt. Nach der Herstellung der Schichtstruktur inklusive aller Silizium-Spikes wird ein thermisches Ausheilen bei einer Temperatur von wenigstens 650 °C durchgeführt.

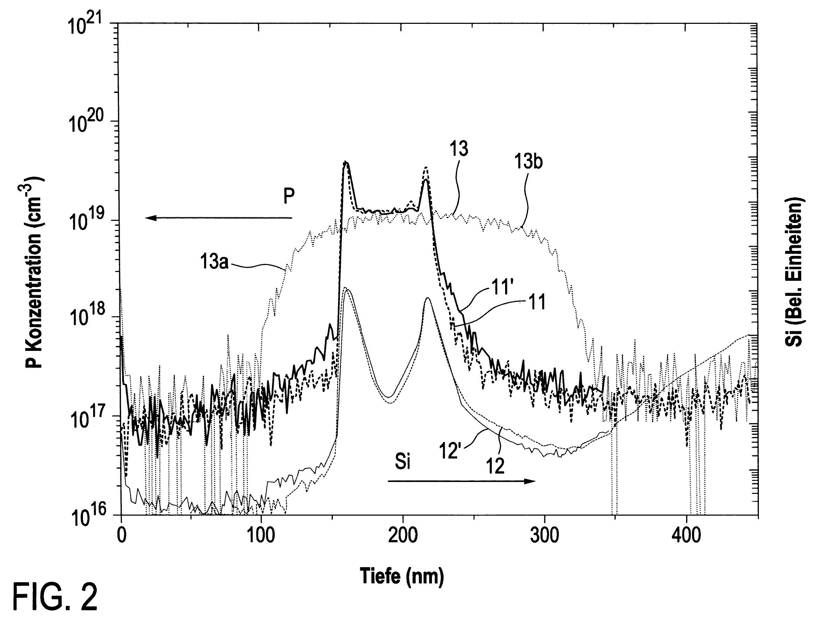

Fig. 2 zeigt ein Dotierstoff-Tiefenprofil und ein Barrierenmaterial-Tiefenprofil in Germanium bei einer Verfahrensführung gemäß der Erfindung im Vergleich mit einer Verfahrensführung gemäß dem Stand der Technik. Eine Verteilung der Phosphor-Konzentration wurde mit Hilfe der Sekundär-Ionen-Massen-Spektrometrie (SIMS) aufgenommen und ist in einer Messkurve 11 dargestellt. Eine Verteilung in der von der Oberfläche aus gemessenen Tiefe ist in Fig. 2 durch die Kurve 12 angezeigt. Nachdem das Substrat und die darauf abgeschiedene Schichtfolge bei Temperaturen von 650 °C ausgeheilt werden, ist eine durch die Kurve 11' bzw. 12' erreichte Tiefenverteilung von Phosphor bzw. Silizium in der Schichtstruktur zu beobachten. Dabei ist ersichtlich, dass sich die Verteilungen 11' und 12' von den vor dem Ausheilschritt aufgenommenen, entsprechenden Verteilungen 11 und 12 nur geringfügig unterscheiden. Lediglich in einer Tiefe von etwa 250 nm, also zum Substrat hin gerichtet, ist eine geringfügige Verbreiterung des Phosphor-Profils zu beobachten. Das Silizium-Profil weist auch geringe, in den Verteilungsausläufern zu verzeichnende Verbreiterungen nach dem Ausheilen auf. In Fig. 2 ist durch das Profil 13 eine Verteilung des Dotierstoffes Phosphor in der Germaniumschicht nach einem Ausheilen bei 650 °C dargestellt, wenn die beschriebene Schichtfolge 10 auf einem Substrat 1 nicht mit den Si-Spikes 3, 8 versehen ist. Im Vergleich zu der scharfen, auch durch die Behandlung bei einer Temperatur von 650°C nicht verbreiterten Verteilung des Dotierstoffs Phosphor hat eine deutliche Verbreiterung der Phosphor-Verteilung sowohl zur Oberfläche als auch zum Substrat 1 hin stattgefunden. Dabei ist eine Asymmetrie der die Verbreiterung der Messkurve 11 zur Messkurve 13 verursachenden Phosphor-Diffusion zugunsten der Substratseite zu beobachten, wie die Ausläufer 13a und 13b des Profils nach Fig. 2 zeigen.

Das erfindungsgemäße Verfahren zur Verhinderung bzw. zumindest Begrenzung einer Phosphor-Diffusion in Germanium findet Einsatz bei der Herstellung von Halbleiterbauelementen wie Germanium/Silizium-Avalanche-Photodioden oder Silizium/Germanium-IMPATT-Dioden (Impact Ionisation Avalanche Transit Time). Ferner werden nachfolgend exemplarisch zwei Ausführungen eines Halbleiterbauelements beschrieben, die jedoch nicht beschränkend für die erfindungsgemäßen Halbleiterbauelemente, die u.a. als optische Empfänger, optische Hochfrequenzemitter oder mit Glasfasern gekoppelte Bauelemente, die zu einer Hochgeschwindigkeitssignalverarbeitung ausgebildet sind, Verwendung finden.

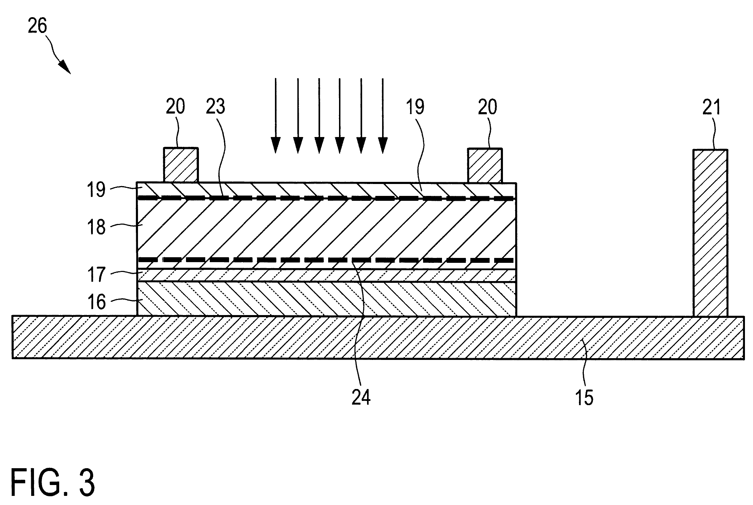

Nach Fig. 3 wird auf ein mit einer Dotierung von 1x10¹⁸ cm⁻³ dotiertes p+-Silizium-Substrat 15 eine einen gleichen Leitfähigkeitstyp aufweisende, mit einer Konzentration von 1x10¹⁶ cm⁻³ dotierte p-Siliziumschicht 16 und einer Dicke von 500 nm aufgebracht. Auf die p-Siliziumschicht 16 folgt eine einen entgegengesetzten Leitungstyp, den Elektronen-Leitungstyp, aufweisende n-Siliziumschicht 17 mit einer Dicke von 100 nm. Diese n-Siliziumschicht 17 weist eine N-Dotierung von 1x10¹⁷ cm⁻³ auf. An die n-Siliziumschicht 17 schließt sich eine 500 bis 1000 nm dicke Germaniumschicht 18 an, die wiederum elektronenleitend ist und dazu mit ungefähr 10¹⁶ cm⁻³ Dotier-Atomen versehen ist. Zum Abschluss der Schichtfolge ist auf die n-Germaniumschicht 18 eine mit mehr als 2x10¹⁸ cm⁻³ um zwei Größenordnungen stärker dotierte Germaniumschicht 19 aufgebracht. Auf einer Oberseite der n+-Germaniumschicht 19 ist zu den seitlichen Enden der Schicht hin jeweils ein Metallisierungsstreifen 20 zur außenseitigen elektrischen Kontaktierung aufgebracht. Wie in Fig. 3 schematisch dargestellt, ist beabstandet zu der gerade beschriebenen Schichtfolge eine weitere Metallisierung 21 so vorgesehen, dass diese einen elektrischen Kontakt zu dem p+-Silizium-Substrat 15 aufweist. Anstelle des p+-Silizium-Substrats 15 kann auch ein hochohmiges Silizium-Substrat verwendet werden, das im entsprechenden Oberflächenbereich zu einer p+-Schicht dotiert ist oder auf das eine p+-Schicht aufgebracht ist.

In der 500 bis 1000 nm dicken n-Germaniumschicht 18 sind nun zur Oberseite und zur Unterseite hin Silizium-Spikes 23, 24 eingebracht. Dabei kann wie in Fig. 3 gezeigt der obere Silizium-Spike 23 genau auf der Grenzfläche zwischen der n+-Germaniumschicht 19 und der n-Germaniumschicht 18 vorgesehen sein, wohingegen der zum Substrat 15 hin vorgesehene Silizium-Spike 24 auch innerhalb der n-Germaniumschicht 18 angebracht sein kann.

Durch eine Bestrahlung von Licht aus dem Spektralbereich von 1300 bis 1600 nm, die durch die Pfeile 25 in Fig. 3 veranschaulicht ist, können nun in der sich zwischen den n-Germaniumschichten und den p-Siliziumschichten ausbildenden Verarmungszone Elektron-Lochpaare erzeugt werden, die an den externen Kontakten 20 und 21 als Stromfluss detektierbar sind. In einem solchen Fall wird das in Fig. 3 schematisch dargestellte, insgesamt mit dem Bezugszeichen 26 bezeichnete Halbleiterbauelement als Photodetektor eingesetzt.

In dem Halbleiterbauelement 26 kommt der Schicht 17, die den Übergang von dem Halbleitermaterial Germanium zu dem Halbleitermaterial Silizium bildet, die Aufgabe einer Anpassungsschicht zwischen den unterschiedlichen Gitterkonstanten des Halbleitermaterials Silizium und Germanium zu, sodass diese Schicht unter einer mechanischen Spannung steht. Durch diese Spannung ist eine Verschiebung der Energie der Bandlücke des Halbleitermaterials Silizium im Vergleich zu einem nicht unter einer mechanischen Spannung stehenden Halbleitermaterial Silizium zu beobachten. Diese Verschiebung der Bandlücke hat nun neben anderen Faktoren auch einen Einfluss auf das Absorptions- bzw. Emissionsverhalten des Halbleiterbauelementes 26. Denn das optische Verhalten der Struktur 26 wird durch die Deckschicht 19 wesentlich bestimmt. Die Deckschicht 19 ist mit einer derart hohen Phosphor-Dotierstoffkonzentration versehen, die zur Besetzung oberhalb der minimalen Bandlücke des Germaniums von 0,66 eV liegender elektronischer Zustände ausreicht.

Die durch die quantenmechanische Beschreibung des Einflusses der Kristallstruktur auf ein freies Elektronengas mit Hilfe von Wellenvektoren (k-Vektoren) darstellbare Bandstruktur des Halbleitermaterials Germanium weist im mehrdimensionalen k-Raum bei verschiedenen Wellenvektoren Minima des Leitungsbandes auf. Diese liegen auch in anderen kristallographischen Richtungen bzw. bei andern Wellenvektoren des k-Raums als das Valenzbandmaximum. Dasjenige Minimum des Leitungsbands mit dem geringsten energetischen Abstand zum Maximum des Valenzbandes ist das in einer (111) Richtung liegende L-Leitungsbandminimum, das einen energetischen Abstand von 0,66 eV von der energetisch obersten Valenzbandkante des Germaniums aufweist. Das bei der gleichen kristallographischen bzw. k-Vektor-Orientierung und damit am ┌-Punkt direkt oberhalb des Valenzbandmaximums liegende Leitungsbandminimum des Germaniums weist dagegen einen Abstand von ca. 0,8 eV zu dem Valenzband auf.

Wenn nun durch die Ionisierung der der Germaniumschicht 19 zugegebenen Phosphor-atome Elektronen erzeugt werden, können diese freie Zustände in dem L-Bandminimum besetzen. Sofern die durch die Phosphor-Dotierung erzeugten Elektronen in einer Vielzahl auftreten, dass die Zustände des L-Leitungsbandminimums des Germaniums so weit aufgefüllt sind, dass die jeweils energetisch höchstliegenden und damit zuletzt besetzten Zustände einen Abstand von etwa der Größe der direkten, am ┌-Punkt vorliegenden Bandlücke des Germaniums in Höhe von etwa 0,8 eV aufweisen, werden durch weitere Anhebung von Elektronen Zustände im ┌-Leitungsbandminimum besetzt. Durch Verwendung der Si-Spikes kann die Phosphor-Dotierung der Germaniumschicht 19 nun so hoch bemessen werden, dass ausreichend viele elektronische Zustände am L-Leitungsbandminimum besetzt werden und somit die energetisch nächst zu besetzenden Zustände diejenigen oberhalb des ┌-Leitungsbandminimums sind. In einem solchen Fall werden durch die Einstrahlung von Licht mit entsprechender Energie - wie schematisch durch die Pfeile 25 in Fig. 3 angezeigt - Elektronen aus dem Valenzband in das L-Leitungsbandminimum angehoben, wodurch unter entsprechender Bewegung der zurückgelassenen Löcher und der Elektronen zwischen den äußeren Kontakten 20 und 21 ein Photostrom detektierbar ist.

Bei derartigen Vorgängen bzw. der inversen Erzeugung eines strahlenden Übergangs durch eine entsprechende Spannungsbeschaltung der Kontakte 20, 21 wird die Übergangswahrscheinlichkeit deutlich erhöht. Denn ein Impulsübertrag von einem Valenzbandmaximum zu einem Leitungsbandminimum mit Hilfe von Gitterschwingungen (Phononen) ist nicht mehr notwendig. Daher sind derartige als Licht-emittierende Bauelemente eingesetzte Strukturen sehr wirkungsvoll.

Es muss nun sichergestellt bleiben, dass die Deckschicht 19 ihre hohe Phosphor-Konzentration sowohl nach den für die Schichtabscheidungen notwendigen Prozessschritten als auch nach nachfolgenden Wärmebehandlungen behält. Das heißt, es muss eine Diffusion der Phosphor-Atome in darunter liegende Halbleiterschichten verhindert, zumindest aber begrenzt werden. Dies wird erfindungsgemäß durch das Vorsehen der als Deltadotierung oder Spikes bezeichneten dünnen, siliziumdotierten Schichten 23, 24 er-reicht, deren Wirkung anhand der mit Hilfe der Sekundär-Ionen-Massen-Spektometrie (SIMS) aufgenommenen Profilverläufe dargelegt worden ist.

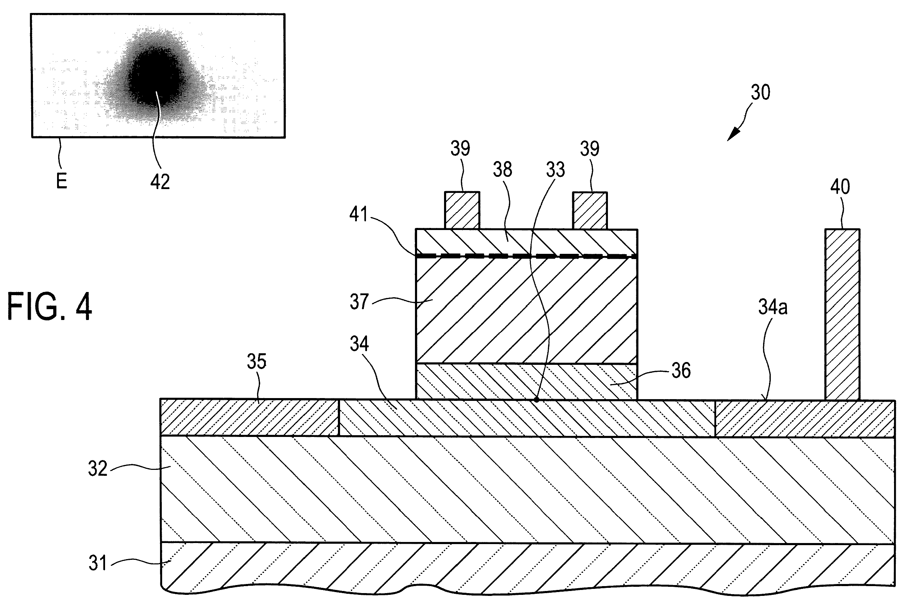

Eine in Fig. 4 dargestellte weitere Ausführungsform des erfindungsgemäßen Halbleiterbauelements weist einen einer IMPATT-Diode entsprechenden Aufbau auf. Dabei ist auf einem Silizium-Substrat 31 ein Siliziumoxid 32 aufgebracht, oberhalb dessen sich eine Schichtfolge in MESA-artigem Aufbau befindet. Dieser setzt sich zentral mit einer p-Siliziumschicht 33 einer Dotierung <1x10¹⁶ cm⁻³ fort, die im Wesentlichen invers T-förmig aufgebaut ist. Seitlich des Basisabschnitts 34 der p-Siliziumschicht 33 ist jeweils eine hochdotierte p+-Siliziumschicht 35 mit einer über Löcher dominierten Leitung vorgesehen. Die p+-Siliziumschichten 35 weisen eine Dotierung von ungefähr 1x10¹⁹ cm⁻³ auf und bilden mit dem Basisabschnitt 34 der p-Siliziumschicht 33 beidseitig eine Ebene 34a, aus der die p-Siliziumschicht 33 mit einem Schaftabschnitt 36 über eine Länge von 100 nm in Richtung zur freien Oberfläche senkrecht hervorragt. Auf den Schaftabschnitt 36 der p-Siliziumschicht 33 ist eine 400 nm dicke elektronenleitende n-Germaniumschicht 37 aufgebracht, deren Donatorkonzentration ungefähr 10¹⁶ cm⁻³ beträgt. Den tafelbergartigen (Mesa-artigen) Aufbau schließt eine im Vergleich zu den anderen Schichten mit 50 nm dünne, hochdotierte elektronenleitende n+-Germaniumschicht 38 einer Dotierung von >2x10¹⁸ cm⁻³ zur freien Oberfläche hin ab. Lateral ist seitlich jeweils eine Metallisierung 39 auf der n+-Germaniumschicht 38 angebracht.

Die Metallisierungen 39 dienen gemeinsam mit einer schematisch dargestellten, mit der auf der Siliziumoxid-Schicht 32 befindlichen p+-Siliziumschicht 35 auf einer Seite der MESA-Struktur verbundenen Metallisierung 40 zum Anlegen von entsprechenden Durchlass- oder Sperrspannungen. Ebenso können zwischen den elektrische Kontakte bildenden Metallisierungen 39 und 40 durch Ladungsträger in Form von Elektronen oder Löchern, die durch eine Infrarotlichteinstrahlung erzeugt sind, bedingte Spannungen bzw. Ströme nach außen geführt und nachgewiesen werden.

Erfindungsgemäß ist nahe einer Grenzschicht 41 zwischen der Deckschicht 38 und der darunter befindlichen n-Germaniumschicht 37 ein dünner, wenige Nanometer betragender Silizium-Spike vorgesehen. Er dient einer Unterbindung bzw. zumindest Begrenzung einer Diffusion von die elektrische Leitfähigkeit der n+-Germaniumschicht 38 bestimmenden Phosphor-Dotieratomen. Diese in einer hohen Konzentration von über 10¹⁸ cm⁻³ in die Schicht 38 eingebrachten Phosphor-Atome sind dazu bestimmt, Elektronen in einer Anzahl bzw. Dichte abzugeben, die zum Ausfüllen von freien elektronischen Zuständen im L-Leitungsbandminimum des Germaniums dienen. Durch eine Einstellung von elektrischen Größen an dem Halbleiterbauelement 30 oder durch eine Bestrahlung mit Infrarotlicht erzeugte Elektronen werden dann aus dem Valenzband in Zustände oberhalb des ┌-Leitungsbandminimums angehoben. Sofern von dort eine Aussendung von Licht erfolgt, ist diese aufgrund des direkten Überganges, zu dem es keiner Phononenunterstützung bedarf im Verhältnis zu intrinsischem Germanium ebenfalls übermäßig bevorzugt.

Zum Erhalten dieser Bedingung während einer Betriebszeit des Halbleiterbauelementes 30 in Form einer IMPATT-Struktur eine Ausdiffusion der Phosphor-Atome aus der n+-Germanium-Struktur 38 vermieden werden. Denn durch eine Ausdiffusion der Phosphor-Atome würde die Konzentration innerhalb der n+-Germaniumschicht 38 unterhalb eine Größe fallen, die für eine Einstellung der Eigenschaften eines direkten Halbleitereis erforderlich ist. Dadurch wäre die Quantenausbeute bzw. Einsatzvielfältigkeit des erfindungsgemäßen Halbleiterbauelements 30 zunehmend eingeschränkt. Die Begrenzung der Phosphor-Atome auf die n+-Germaniumschicht 38 wird durch den diese nach unten zum Substrat hin umgebenden Si-Spike begrenzt. Die Si-Spikes können die auf unterschiedliche Weisen, wie etwa durch Implantation oder MBE, MOCVD, vorzugsweise unter Verwendung von Atomic Layer Processing oder vergleichbarer Techniken hergestellt werden.

Bei der beispielhaften, in Fig. 4 gezeigten Ausführung des erfindungsgemäßen Halbleiterbauelementes 30 handelt es sich um eine zweiseitig symmetrische abgeruppte p+-p-n-n+-Diode und damit eine Doppeldrift-Diode. Diese Dioden finden hauptsächlich Einsatz als Avalanche-Dioden, bei denen durch einen Lawinendurchbruch einer in Sperrspannung vorgespannten Diode große Ströme transportiert werden können.

Sowohl bei der in Fig. 3 als auch bei der in Fig. 4 gezeigten Ausführungsform 26, 30 des erfindungsgemäßen Halbleiterbauelementes ist eine genaue Einstellung der Dicke der oberen n+-Germanium-Deckschicht 19 bzw. 38 erforderlich, um einen stabilen Betriebspunkt und damit einen festen Verstärkungsfaktor der zur Signalübertragung eingesetzten Halbleiterbauelemente einstellen zu können. In einer Weiterentwicklung ist es im Rahmen der Erfindung vorgesehen, den MESA-Aufbau gemäß Fig. 4, wie in dem Einsatz E grob vereinfacht dargestellt, mit einem Wellenleiter 42 zu kombinieren, um eine effiziente Einkopplung des durch entsprechende elektrische Beschaltung des Halbleiterbauelementes 30 emittierte Strahlung zu erreichen. Die halbleitertechnologische Verbindung bzw. Ankopplung des Wellenleiters geschieht dabei in an sich bekannter und der derzeitigen Technologie entsprechenden Art und Weise.

## Patentansprüche

1. Verfahren zur Herstellung eines Halbleiterbauelements, umfassend:
Herstellen einer Schichtstruktur, die eine mit Phosphor als Dotierstoff versehene Germaniumschicht mindestens eine an die Germaniumschicht angrenzende Nachbarschicht aufweist,
wobei die Nachbarschicht nicht oder in einer anderen Konzentration als die Germaniumschicht mit Phosphor dotiert wird, **dadurch gekennzeichnet, dass**
mindestens eine Deltadotierung (3) mit Silizium entweder in der Germaniumschicht oder in der Nachbarschicht angeordnet wird, bevor die Schichtstruktur in einem Prozessschritt einer Temperatur von 550 °C oder höher ausgesetzt wird.

2. Verfahren nach Anspruch 1, bei der die Deltadotierung mit Silizium in einer Schichtdicke hergestellt wird, welche geeignet ist, unter Temperaturen bis zu einem Maximalwert zwischen 600 °C und 750°C eine Diffusion des Dotierstoffs Phosphor zwischen der Germaniumschicht und der Nachbarschicht durch die Deltadotierung hindurch vollständig zu vermeiden oder im Vergleich mit einer ohne die Deltadotierung hergestellten Schichtstruktur zu reduzieren.

3. Verfahren nach Anspruch 1 oder 2, bei dem die Deltadotierung mit Silizium mit einer Dosis erfolgt, welche der Dosis einer ganzflächigen Abscheidung von Silizium mit einer Schichtdicke von 1 bis 4 Monolagen entspricht.

4. Verfahren nach einem der vorstehenden Ansprüche, bei dem die Deltadotierung in einem Schichtabschnitt einer Dicke von zwischen 1 und 10 Monolagen der Germaniumschicht oder der Nachbarschicht hergestellt wird.

5. Verfahren nach einem der vorstehenden Ansprüche, bei dem zur Dotierung mit Phosphor eine Phosphorabscheidung in situ auf einer Germaniumoberfläche während einer Wachstumsunterbrechung der in Herstellung befindlichen Germaniumschicht oder mittels Phosphor-Koabscheidung bei der Herstellung der Germaniumschicht erfolgt.

6. Verfahren nach Anspruch 5, bei dem Phosphor bei einer Temperatur zwischen 200 °C und 450 °C, abgeschieden wird und im Abstand von jeweils etwa 1 nm unterhalb und oberhalb des abgeschiedenen Phosphors jeweils eine Deltadotierung der Germaniumschicht mit Silizium erfolgt.

7. Verfahren nach einem der vorstehenden Ansprüche, bei dem die Deltadotierung mittels Atomic Layer Processing hergestellt wird.

8. Halbleiterbauelement (26, 30) mit einer Schichtstruktur, die eine mit Phosphor als Dotierstoff versehene Germaniumschicht (5) aufweist, **dadurch gekennzeichnet, dass** mindestens eine Deltadotierung (3) mit Silizium entweder in der Germaniumschicht oder in mindestens einer an die Germaniumschicht angrenzenden Nachbarschicht der Schichtstruktur angeordnet ist, und wobei die Nachbarschicht nicht oder in einer anderen Konzentration als die Germaniumschicht mit Phosphor dotiert ist.

9. Halbleiterbauelement (26, 30) nach Anspruch 8, bei dem die Deltadotierung in einem Schichtabschnitt einer Dicke von zwischen 1 und 10 Monolagen der Germaniumschicht oder der Nachbarschicht vollständig enthalten ist.

10. Halbleiterbauelement nach Anspruch 8 oder 9, mit einem Substrat (15; 31), das eine Substratoberfläche aus Silizium oder Germanium aufweist, mit wenigstens einer auf der Substratoberfläche (15; 31) aufgebrachten, dotierten Siliziumschicht (16; 33) eines ersten Leitfähigkeitstyps, mit einer auf der dotierten Siliziumschicht (16; 33) aufgebrachten, die Germaniumschicht bildenden ersten Germaniumschicht (18; 37) und einer auf dieser aufgebrachten, die Nachbarschicht bildenden zweiten Germaniumschicht (19; 38),
wobei die erste (18; 37) und die zweite (19; 38) Germaniumschicht einen dem ersten Leitfähigkeitstyp entgegengesetzten Leitfähigkeitstyp aufweisen,
wobei die zweite Germaniumschicht (19; 38) höher dotiert als die erste Germaniumschicht (18; 37) ist und
wobei die erste Germaniumschicht (18; 37) nahe ihrer vom Substrat (15; 31) abgewandten Grenzfläche (41) die Deltadotierung mit Silizium (23) einmal oder mit Abstand wiederholt aufweist.

11. Halbleiterbauelement nach einem der Ansprüche 8 bis 10, bei dem die erste Germaniumschicht (18) zusätzlich nahe ihrer der Substratoberfläche (15) zugewandten Grenzfläche die Deltadotierung mit Silizium (23) einmal oder mit Abstand wiederholt aufweist.

12. Halbleiterbauelement nach einem der Ansprüche 8 bis 11, bei dem zwischen der wenigstens einen Siliziumschicht (33) und der Substratoberfläche (31) eine Oxidschicht (32) vorgesehen ist.

13. Halbleiterbauelement nach einem der Ansprüche 8 bis 12, bei dem die zweite Germaniumschicht (19; 38) mit wenigstens einem Kontakt (20; 39) versehen ist.

14. Halbleiterbauelement nach einem der Ansprüche 8 bis 13, welches als Licht emittierende Diode oder als Laserdiode ausgebildet ist.

15. Halbleiterbauelement nach einem der Ansprüche 8 bis 13, welches als Licht detektierende Diode ausgebildet ist.

## Claims

1. Method for producing a semiconductor component, comprising:
producing a layer structure which comprises a germanium layer provided with phosphorus as a doping agent, at least one neighbouring layer adjacent to the germanium layer,
the neighbouring layer not being doped or being doped with phosphorus in a concentration which is different from the germanium layer, **characterised in that**
at least one region delta-doped (3) with silicon is arranged either in the germanium layer or in the neighbouring layer, prior to the layer structure being exposed to a temperature of 550 °C or higher in a process step.

2. Method according to claim 1, in which the region is delta-doped with silicon in a layer thickness which, at temperatures up to a maximum value of between 600 °C and 750 °C, is suitable for completely preventing, or reducing in comparison with a layer structure produced without the delta-doped region, diffusion of the doping agent, phosphorus, between the germanium layer and the neighbouring layer through the delta-doped region.

3. Method according to either claim 1 or claim 2, in which the region is delta-doped with silicon at a dose which corresponds to the dose of a whole-surface deposition of silicon having a layer thickness of from 1 to 4 monolayers.

4. Method according to any of the preceding claims, in which the region is delta-doped in a layer portion of the germanium layer or the neighbouring layer having a thickness of between 1 and 10 monolayers.

5. Method according to any of the preceding claims, in which, for doping with phosphorus, phosphorus is deposited in situ on a germanium surface during a period of growth interruption of the germanium layer being produced or by means of phosphorus codeposition during the production of the germanium layer.

6. Method according to claim 5, in which phosphorus is deposited at a temperature of between 200 °C and 450 °C and in each case the germanium layer is delta-doped with silicon at intervals of approximately 1 nm in each case, underneath and above the deposited phosphorus.

7. Method according to any of the preceding claims, in which the delta doping is produced by means of atomic layer processing.

8. Semiconductor component (26, 30) having a layer structure which comprises a germanium layer (5) provided with phosphorus as the doping agent, **characterised in that** at least one region delta-doped (3) with silicon is arranged either in the germanium layer or in at least one neighbouring layer of the layer structure which is adjacent to the germanium layer, and the neighbouring layer not being doped or being doped with phosphorus in a concentration which is different from the germanium layer.

9. Semiconductor component (26, 30) according to claim 8, in which the delta doped region is completely contained in a layer portion of the germanium layer or the neighbouring layer having a thickness of between 1 and 10 monolayers.

10. Semiconductor component according to either claim 8 or claim 9, comprising a substrate (15; 31) that has a substrate surface made of silicon or germanium, at least one doped silicon layer (16; 33), which is applied to the substrate surface (15; 31), of a first conductivity type, a first germanium layer (18; 37) which is applied to the doped silicon layer (16; 33) and forms the germanium layer, and a second germanium layer (19; 38) which is applied to said first germanium layer and forms the neighbouring layer,
wherein the first (18; 37) and the second (19; 38) germanium layers comprise a conductivity type which is the reverse of the first conductivity type,
wherein the second germanium layer (19, 38) is more highly doped than the first germanium layer (18; 37) and
wherein, close to its interface (41) that faces away from the substrate (15; 31), the first germanium layer (18; 37) comprises the region that is delta-doped with silicon (23) either once or repeatedly at intervals.

11. Semiconductor component according to any of claims 8 to 10, in which, also close to its interface that faces the substrate surface (15), the first germanium layer (18) comprises the region that is delta-doped with silicon (23) either once or repeatedly at intervals.

12. Semiconductor component according to any of claims 8 to 11, in which an oxide layer (32) is provided between the at least one silicon layer (33) and the substrate surface (31).

13. Semiconductor component according to any of claims 8 to 12, in which the second germanium layer (19; 38) is provided with at least one contact (20; 39).

14. Semiconductor component according to any of claims 8 to 13, which is in the form of a light-emitting diode or a laser diode.

15. Semiconductor component according to any of claims 8 to 13, which is in the form of a light-detecting diode.

## Revendications

1. Procédé de fabrication d'un composant semi-conducteur, comprenant l'étape consistant à :
fabriquer une structure en couches présentant une couche de germanium munie de phosphore comme dopant et au moins une couche voisine de la couche de germanium,
dans lequel la couche voisine n'est dopée au phosphore ou alors à une concentration différente de la couche de germanium,
**caractérisé en ce qu'**au moins un dopage delta (3) au silicium est disposé soit dans la couche de germanium soit dans la couche voisine avant que la structure en couches ne soit exposée à une température de 550 °C ou plus au cours d'une étape du processus.

2. Procédé selon la revendication 1, dans lequel le dopage delta au silicium est établi dans une épaisseur de couche adaptée pour éviter complètement, à des températures jusqu'à une valeur maximale comprise entre 600 °C et 750 °C, une diffusion du dopant de phosphore entre la couche de germanium et la couche voisine à travers le dopage delta, ou bien pour la réduire en comparaison avec une structure en couches fabriquée sans dopage delta.

3. Procédé selon la revendication 1 ou 2, dans lequel le dopage delta au silicium est effectué à un dosage correspondant au dosage d'un dépôt chimique de silicium sur toute la surface avec une épaisseur de couche de 1 à 4 couches monomoléculaires.

4. Procédé selon l'une quelconque des revendications précédentes, dans lequel le dopage delta est établi dans une portion de couche d'une épaisseur comprise entre 1 et 10 couches monomoléculaires de la couche de germanium ou de la couche voisine.

5. Procédé selon l'une quelconque des revendications précédentes, dans lequel, pour le dopage au phosphore, un dépôt chimique de phosphore in situ sur une surface de germanium est effectuée pendant une interruption de croissance de la couche de germanium en cours de fabrication ou au moyen d'un co-dépôt chimique de phosphore lors de la fabrication de la couche de germanium.

6. Procédé selon la revendication 5, dans lequel du phosphore est déposé à une température comprise entre 200 °C et 450 °C, et respectivement un dopage delta de la couche de germanium est effectué avec du silicium à un intervalle de respectivement environ 1 nm au-dessous et au-dessus du phosphore déposé.

7. Procédé selon l'une quelconque des revendications précédentes, dans lequel le dopage delta est établi au moyen du « Atomic Layer Processing ».

8. Composant semi-conducteur (26, 30) avec une structure en couches présentant une couche de germanium (5) munie de phosphore comme dopant, **caractérisé en ce qu'**au moins un dopage delta (3) au silicium est disposé soit dans la couche de germanium soit dans au moins une couche voisine de la couche de germanium, et dans lequel la couche voisine n'est pas dopée au phosphore ou alors à une concentration différente de la couche de germanium.

9. Composant semi-conducteur (26, 30) selon la revendication 8, dans lequel le dopage delta est entièrement compris dans une portion de couche d'une épaisseur comprise entre 1 et 10 couches monomoléculaires de la couche de germanium ou de la couche voisine.

10. Composant semi-conducteur selon la revendication 8 ou 9, avec un substrat (15 ; 31) présentant une surface de substrat en silicium ou en germanium, avec au moins une couche de silicium (16 ; 33) dopée, appliquée à la surface de substrat (15 ; 31), d'un premier type de conductivité, avec une première couche de germanium (18 ; 37) appliquée à la couche de silicium (16 ; 33) dopée et formant la couche de germanium et une deuxième couche de germanium (19 ; 38) appliquée à celle-ci et formant la couche voisine,
dans lequel les première (18 ; 37) et deuxième (19 ; 38) couches de germanium présentent un type de conductivité opposé au premier type de conductivité,
dans lequel la deuxième couche de germanium (19 ; 38) est dopée plus fortement que la première couche de germanium (18 ; 37), et
dans lequel la première couche de germanium (18 ; 37) présente à proximité de son interface (41) détournée du substrat (15 ; 31) le dopage delta au silicium (23) une seule fois ou plusieurs fois à intervalles.

11. Composant semi-conducteur selon l'une quelconque des revendications 8 à 10, dans lequel la première couche de germanium (18) présente de plus à proximité de son interface tournée vers la surface de substrat (15) le dopage delta au silicium (23) une seule fois ou plusieurs fois à intervalles.

12. Composant semi-conducteur selon l'une quelconque des revendications 8 à 11, dans lequel une couche d'oxyde (32) est prévue entre ladite au moins une couche de silicium (33) et la surface de substrat (31).

13. Composant semi-conducteur selon l'une quelconque des revendications 8 à 12, dans lequel la deuxième couche de germanium (19 ; 38) est munie d'au moins un contact (20 ; 39).

14. Composant semi-conducteur selon l'une quelconque des revendications 8 à 13, réalisé sous forme de diode photoémettrice ou de diode laser.

15. Composant semi-conducteur selon l'une quelconque des revendications 8 à 13, réalisé sous forme de diode photodétectrice.
